# EUROPÄISCHE PATENTSCHRIFT

(11) **EP 3 216 088 B1**
(45) Veröffentlichungstag und Bekanntmachung des Hinweises auf die Patenterteilung: **01.08.2018**
(21) Anmeldenummer: 15786867.0
(22) Anmeldetag: 21.10.2015
(51) Int. Cl.: H01R 13/6463, H01R 12/51, H01R 12/72

(54) **LEITERPLATTENANORDNUNG**
PRINTED CIRCUIT BOARD ASSEMBLY
ENSEMBLE CARTE DE CIRCUIT IMPRIMÉ

(30) Priorität: 06.11.2014 DE 202014008843 U
(43) Veröffentlichungstag der Anmeldung: 13.09.2017
(73) Patentinhaber: Rosenberger Hochfrequenztechnik GmbH & Co. KG, 83413 Fridolfing (DE)
(72) Erfinder: SCHMIDT, Christian, 92533 Wernberg-Köblitz (DE); ZEBHAUSER, Martin, 83410 Laufen (DE)
(74) Vertreter: Zeitler Volpert Kandlbinder Patent- und Rechtsanwälte Partnerschaft mbB
(86) Internationale Anmeldenummer: PCT/EP2015/002083
(87) Internationale Veröffentlichungsnummer: WO 2016/070958

(56) Entgegenhaltungen:
- DE-U1-202013 006 295
- US-A1- 2013 316 585
- US-A1- 2014 017 956

## Beschreibung

Die Erfindung betrifft eine Leiterplattenanordnung mit einer Leiterplatte und einem daran befestigten Steckverbinder. Dazu weist die Leiterplatte zumindest einen Footprint mit drei oder mehr Ankoppelpunkten auf, die zum Ankoppeln von elektrischen Kontakten des Steckverbinders eingerichtet sind.
Unter einem Footprint wird allgemein ein in einem bestimmten Layout auf der Leiterplatte oder Platine vorgesehener Landepunkt für ein bestimmtes Bauteil verstanden. Ein fertiges Leiterplattendesign besteht aus einer Vielzahl solcher Bauteil-Landepunkte, die durch Leiterbahnen miteinander verbindbar sind. Jedes Bauteil weist eine bestimmte Anzahl von elektrischen Kontakten in einer bestimmten räumlichen Anordnung auf, die regelmäßig mit einer entsprechenden Anzahl von Gegenkontakten der Leiterplatte zu verbinden sind. Deshalb passt zu jedem Bauteil wie etwa einem bestimmten Leiterplatten-Stecker oder einem anderen elektronischen Bauelement jeweils ein ganz bestimmter Footprint auf der Leiterplatte. Ein solches Ankoppeln der einzelnen Bauteilkontakte an die einzelnen Ankoppelpunkte erfolgt regelmäßig mittels Verlöten.
Regelmäßig ist es erforderlich, bestimmte Signale oder Spannungen mittels eines Kabels in die elektrische Schaltung auf der Leiterplatte einzuleiten bzw. von der Leiterplatte abzuleiten. Zu diesem Zweck können auf der Leiterplatte Leiterplatten-Steckverbinder befestigt werden, die zum Einstecken eines Gegensteckers des Kabels vorgesehen sind. Wie erläutert, ist jeder Art von Steckverbinder ein bestimmter Footprint zugeordnet. Zu einem vier Signalleiter aufweisenden Steckverbinder gehört bspw. üblicherweise ein Footprint mit vier Ankoppelpunkten zum Ankoppeln jeweils eines elektrischen Kontakts der einzelnen Signalleiter.

Eine Leiterplattenanordnung nach dem Oberbegriff des Anspruchs 1 ist aus US-A-2013/316585 bekannt.

Ein Neudesign einer mit der Leiterplatte verbundenen Hardware oder Software führt allerdings regelmäßig dazu, dass der Leiterplatte weniger elektrische Signale zuzuführen sind als vorher, so dass ein Steckverbinder mit weniger Signalleitern als zuvor ausreichend sein kann. Ein Austausch von Steckverbindern ist jedoch problematisch oder bereit zumindest Montageprobleme, da der auf der Platine vorgesehene Footprint eigentlich an den ursprünglichen Steckverbinder angepasst ist. Insbesondere kann ein Austausch von Steckverbindern zu einer Verschlechterung der Signalqualität der noch benötigten Signale führen.
In Anbetracht der beschriebenen Probleme ist es die Aufgabe der vorliegenden Erfindung, eine einfach montierbare Leiterplattenanordnung unter Beibehaltung einer optimalen Signalqualität im Anschluss an ein solches Neudesign bereitzustellen.
Diese Aufgabe wird durch eine Leiterplattenanordnung gemäß Anspruch 1 gelöst. Vorteilhafte Weiterbildungen der Erfindung sind in den abhängigen Ansprüchen beschrieben.
Der an der Leiterplatte befestigte Steckverbinder weist genau zwei Signalleiter zum Übertragen eines differentiellen Signals auf, wobei der erste Signalleiter einen an einen ersten Ankoppelpunkt gekoppelten ersten elektrischen Kontakt und der zweite Signalleiter einen an einen zweiten Ankoppelpunkt gekoppelten zweiten elektrischen Kontakt aufweist, wobei ein dritter, freier Ankoppelpunkt näher an dem ersten (bzw. zweiten) Ankoppelpunkt als der zweite (bzw. erste) Ankoppelpunkt angeordnet ist.

Mit anderen Worten sind nicht alle der mindestens drei Ankoppelpunkte des Footprints mit elektrischen Kontakten des Steckverbinders besetzt. Vielmehr ist an mindestens einen, bevorzugt an zwei oder mehr Ankoppelpunkte des Footprints kein elektrischer Kontakt des Steckverbinders angekoppelt. Die vorhandenen zwei elektrischen Kontakte, die ein differentielles Kontaktpaar zum Übertragen eines differentiellen Signals bilden, sind an zwei Ankoppelpunkten mit einem großen gegenseitigen Abstand, also nicht an zwei nächst benachbarten Ankoppelpunkten angekoppelt.

Die Erfindung geht auf die Erkenntnis zurück, dass durch einen großen Abstand der beiden Kontaktelemente des Signalleiterpaars zum einen die Montage des Steckverbinders an der Platine vereinfacht wird, da die vergleichsweise große Fläche des überdimensionierten Footprints optimal ausgenutzt wird. Zum anderen können durch den großen Abstand der beiden Kontaktelemente ein versehentliches Kontaktieren der beiden Signalleiter und/oder eine Fehlverlötung zuverlässig verhindert werden. Des Weiteren wird eine Zuordnung der beiden Kontakte gegenüber einer engen Kontaktanordnung vereinfacht und damit u.a. eine Verwechslung beim Verlöten verhindert.

Besonders vorteilhaft in dieser Hinsicht ist eine Anordnung, bei der der erste Ankoppelpunkt und der zweite Ankoppelpunkt zwei Ankoppelpunkte des Footprints mit dem größten gegenseitigen Abstand darstellen. Wenn die geometrische Anordnung der Ankoppelpunkte des Footprints derart gestaltet ist, dass zwischen mehr als einem Paar von Ankoppelpunkten derselbe größte Abstand vorhanden ist, sind die beiden elektrischen Kontakte des Steckverbinders an eines dieser weit beabstandeten Paare von Ankoppelpunkten angekoppelt.

Bei einer besonders bevorzugten Ausführungsform der Erfindung weist der Footprint vier Ankoppelpunkte auf, die in einem vorgegebenen Muster an der Leiterplatte angeordnet sind. So kann der Footprint bspw. zum Ankoppeln eines Vierkontakt-Steckverbinders vorgesehen sein, wobei jedoch aufgrund eines Neudesigns nur noch ein einziges differentielles Signal mittels des Steckverbinders in die Leiterplatte einzuleiten ist.

Dabei hat es sich als zweckmäßig erwiesen, dass die vier Ankoppelpunkte in Form eines Rechtecks, insbesondere in Form eines Quadrats an der Leiterplatte angeordnet sind. Ein derart ausgebildetes Vierkontaktdesign ist nämlich besonders kompakt und ermöglicht eine einfache Zuordnung der einzelnen elektrischen Kontakte. Im Falle einer Rechteckanordnung der Ankoppelpunkte des Footprints sind die zwei elektrischen Kontakte des Steckverbinders an zwei diagonal gegenüberliegenden Ecken des Rechtecks angekoppelt, da diese Ankoppelpunkte weiter voneinander beabstandet sind, als zwei nebeneinanderliegende Ecken des Rechtecks.
Eine einfache und kostengünstige Ankopplung der elektrischen Kontakte an die Ankoppelpunkte wird dadurch ermöglicht, dass die Ankoppelpunkte jeweils Löcher, insbesondere Durchgangslöcher aufweisen, in die die elektrischen Kontakte zum Kontaktieren einführbar sind. Ferner können die elektrischen Kontakte des Steckverbinders als (komplementär zu den Löchern geformte) Pins oder Stifte gebildet sein, die von einer Unterseite des Steckverbinders in Richtung auf die Leiterplatte vorstehen und vorzugsweise in die Löcher der Ankoppelpunkte hineinragen bzw. eingreifen. Alternativ oder zusätzlich können die Ankoppelpunkte Lötpunkte wie etwa Lötpads zum Anlöten der Kontaktelemente aufweisen.
Der Steckverbinder weist vorzugsweise eine zum Ankoppeln eines Twisted-Pair-Kabels eingerichtete Steckgeometrie auf. Mit anderen Worten ist der Steckverbinder zum Verbinden mit einem an ein Twisted-Pair-Kabel angeschlossenen Gegenstecker eingerichtet. Die Signalleiter des Steckverbinders verlaufen ausgehend von den elektrischen Kontakten durch einen ggf. abgeschirmten Hauptteil des Steckverbinders bis hin zu der Steckgeometrie an einem steckseitigen Ende des Steckverbinders. An dem steckseitigen Ende können die Signalleiter Kontaktstifte und/oder Kontaktbuchsen zum Verkuppeln mit komplementären Gegenkontaktelementen des Gegensteckers aufweisen. Der Steckverbinder kann als Winkelstecker gebildet sein, bei dem die elektrischen Kontakte an einer Unterseite vorstehen, während die Steckgeometrie an einer quer, insbesondere senkrecht dazu verlaufenden Seite vorgesehen ist. Dazu weisen die Signalleiter des Steckverbinders vorzugsweise jeweils zumindest einen Knick um etwa 90° auf.
Zur Verbesserung der Befestigungsstabilität des Steckverbinders an der Leiterplatte kann der Steckverbinder mehrere, bevorzugt vier in Befestigungsöffnungen der Leiterplatte eingreifende Befestigungsvorsprünge aufweisen. Die Befestigungsvorsprünge können in Form von Befestigungsstiften gebildet sein, die formschlüssig und/oder kraftschlüssig in den Befestigungsöffnungen aufnehmbar sind.

In einer besonders bevorzugten Ausführungsform der Erfindung ist der Footprint zum Befestigen eines Sternviererkabel-Steckverbinders, insbesondere eines HSD-Steckers, eingerichtet. Ein Sternviererkabel weist zwei Signalleiterpaare auf, die gemeinsam verdrillt sind. Ein Steckviererkabel-Steckverbinder weist entsprechend insgesamt vier Signalleiter auf. Der dazugehörige Footprint hat entsprechend insgesamt vier Ankoppelpunkte. Der erfindungsgemäß daran angekoppelte Steckverbinder ist jedoch nicht der eigentlich vorgesehene HSD-Stecker, sondern ein Twisted-Pair-Kabel-Steckverbinder, insbesondere ein MTD-Stecker, mit nur zwei Signalleitern.

In der nun folgenden Beschreibung wird die Erfindung unter Bezugnahme auf die beigefügten Zeichnungen beispielhaft erläutert. Dabei zeigen:
- Fig. 1a: einen Steckverbinder vor dem Befestigen an einer Leiterplatte,
- Fig. 1b: eine erfindungsgemäße Leiterplattenanordnung, die aus dem Steckverbinder und der Leiterplatte aus Fig. 1a besteht,
- Fig. 2a: einen anderen Steckverbinder vor dem Befestigen an der Leiterplatte, und
- Fig. 2b: eine herkömmliche Leiterplattenanordnung, die aus dem Steckverbinder und der Leiterplatte aus Fig. 2a besteht.

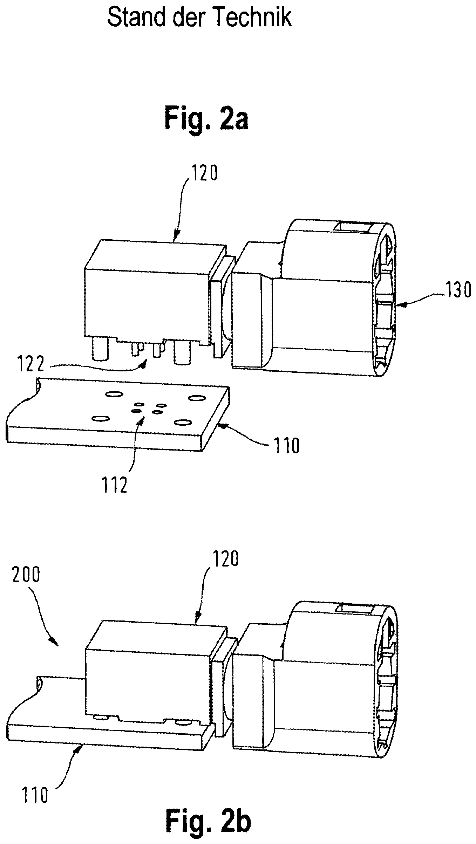

Eine herkömmliche Leiterplattenanordnung 200 ist in Fig. 2b gezeigt. Sie besteht aus einer Leiterplatte 110 und einem daran befestigten Winkelstecker 120 mit vier Signalleitern zur Übertragung von zwei differentiellen Signalen mit insgesamt vier in Richtung auf die Leiterplatte 110 vorstehenden elektrischen Kontakten 122 (siehe Fig. 2a).

Die Leiterplatte 110 weist einen komplementär dazu gebildeten Footprint 112 mit insgesamt vier Ankoppelpunkten auf (siehe Fig. 2a). Die räumliche Anordnung der Ankoppelpunkte entspricht der räumlichen Anordnung der elektrischen Kontakte 122, so dass die elektrischen Kontakte 122 jeweils den zugehörigen Ankoppelpunkt elektrisch kontaktieren, wenn der Steckverbinder 120 an der Leiterplatte 110 befestigt ist (siehe Fig. 2b). Ein steckseitiges Ende des Steckverbinders weist eine Vierkontakt-Steckgeometrie 130 auf, so dass ein Sternviererkabel an den Steckverbinder 120 anschließbar ist. Auf diese Weise sind der Leiterplatte 110 zwei differentielle Signale über das Sternviererkabel zuführbar.

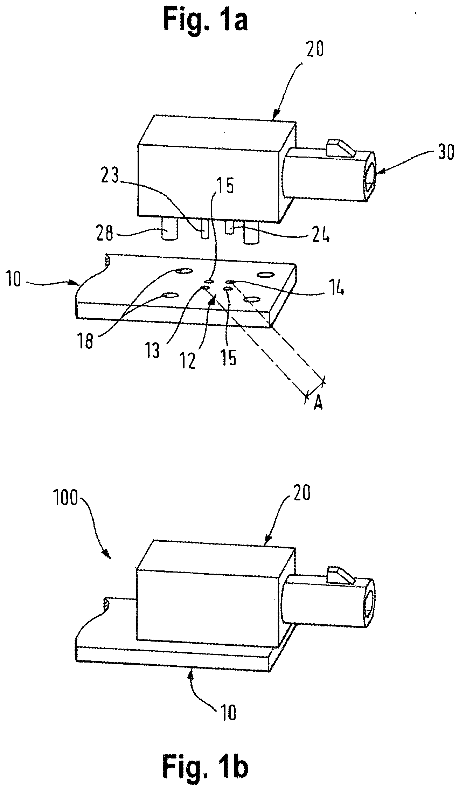

Fig. 1b zeigt eine erfindungsgemäße Leiterplattenanordnung 100. Sie besteht aus einer Leiterplatte 10 und einem daran befestigten Steckverbinder 20 mit nur zwei Signalleitern zur Übertragung eines differentiellen Signals mit zwei in Richtung auf die Leiterplatte 10 vorstehenden elektrischen Kontakten 23, 24 (siehe Fig. 1a).

Die Leiterplatte 10 weist einen Footprint 12 zum Ankoppeln der elektrischen Kontakte 23, 24 mit insgesamt vier Ankoppelpunkten 13, 14, 15 auf (siehe Fig. 1a). Der Footprint 12 entspricht dem Footprint 112 der herkömmlichen Leiterplattenanordnung 200. Mit anderen Worten weist der Footprint 12 mehr Ankoppelpunkte auf als der Steckverbinder 20 elektrische Kontakte aufweist.

Im befestigten Zustand, der in Fig. 1b gezeigt ist, ist der erste elektrische Kontakt 23 des Steckverbinders an einen ersten Ankoppelpunkt 13 und der zweite elektrische Kontakt 24 des Steckverbinders an einen zweiten Ankoppelpunkt 14 des Footprints elektrisch gekoppelt. Folglich ist an den übrigen zwei Ankoppelpunkten 15 kein elektrischer Kontakt angekoppelt.

Erfindungsgemäß wichtig ist, dass die ersten und zweiten Ankoppelpunkte 13, 14 keine einander nächst benachbarten Ankoppelpunkte darstellen. Mit anderen Worten liegt zumindest einer der freien Ankoppelpunkte 15 näher an dem ersten (bzw. zweiten) Ankoppelpunkt als der zweite (bzw. erste) Ankoppelpunkt.

Bei der dargestellten Ausführungsform sind die vier Ankoppelpunkte 13, 14, 15 in Form eines Quadrats angeordnet, wobei die Ankoppelpunkte jeweils eine Ecke des Quadrats bilden. In diesem Fall hat jeder der Ankoppelpunkte zwei nächst benachbarte Ankoppelpunkte (nämlich die benachbarten Ecken des Quadrats) und einen weiter beabstandeten Ankoppelpunkt (nämlich die diagonal gegenüberliegende Ecke des Quadrats). Entsprechend sind die zwei elektrischen Kontakte 23, 24 des Steckverbinders mit zwei Ankoppelpunkten 13, 14 verbunden, die zwei einander diagonal gegenüberliegende Ecken des Quadrats bilden. Damit stellen der erste und der zweite Ankoppelpunkt 13, 14 ein Paar Ankoppelpunkte mit dem größten gegenseitigen Abstand A des Footprints dar.

Auf diese Weise wird erfindungsgemäß zum einen die Montage des Steckverbinders 20 an der Leiterplatte 10 erleichtert und zum anderen die Qualität der zu übertragenden Signale verbessert.

Die Ankoppelpunkte 13, 14, 15 weisen jeweils Löcher zum Einführen der jeweils stiftförmig gebildeten elektrischen Kontakte 23, 24 auf. Die elektrischen Kontakte 23, 24 stehen dabei von einer Unterseite des Steckverbinders 20 in Richtung der Leiterplatte 10 vor. Außerdem stehen ausgehend von der Unterseite des Steckverbinders 20 insgesamt vier Befestigungsstifte 28 vor, die im befestigten Zustand (siehe Fig. 1b) jeweils in eine Befestigungsöffnung 18 der Leiterplatte eingreifen.

Die Steckgeometrie 30 am steckseitigen Ende des Steckverbinders 20 ist zum Verbinden eines Gegensteckers mit zwei ein Signalleiterpaar bildenden Kontakten eingerichtet. Auf diese Weise kann bspw. ein Twisted-Paar-Kabel mit dem Steckverbinder 20 verbunden werden.

In der dargestellten Ausführungsform weist der Footprint ein Platinen-Layout zum Ankoppeln eines Vierkontakt-HSD-Steckverbinders auf, wobei jedoch nicht der eigentlich vorgesehene HSD-Stecker, sondern ein Zweikontakt-MTD-Stecker daran befestigt ist.

Die Erfindung ist nicht auf die beschriebene Ausführungsform beschränkt. Bspw. können die Ankoppelpunkte in einer Reihe nebeneinander angeordnet sein, wobei die zwei elektrischen Kontakte an den beiden äußersten Ankoppelpunkten der Reihe angekoppelt sind. Ferner kann der Footprint mehr als vier, bspw. sechs, acht oder zwölf Ankoppelpunkte aufweisen. Der Steckverbinder kann zusätzlich ein Außenleitergehäuse aus einem leitenden Material aufweisen, das mit einer Masse der Leiterplatte verbunden ist. Andere Ausgestaltungen einer erfindungsgemäßen Leiterplattenanordnung sind ebenfalls vorstellbar.

## Patentansprüche

1. Leiterplattenanordnung (100) mit einer Leiterplatte (10) mit zumindest einem Footprint (12) zum Befestigen eines Steckverbinders (20), wobei der Footprint (12) drei oder mehr Ankoppelpunkte (13, 14, 15) zum Ankoppeln von elektrischen Kontakten (23, 24) des Steckverbinders (20) aufweist,
und mit einem an dem Footprint (12) befestigten Steckverbinder (20),
**dadurch gekennzeichnet,**
**dass** der Steckverbinder (20) genau zwei Signalleiter zum Übertragen eines differentiellen Signals aufweist, wobei der erste Signalleiter einen an einen ersten Ankoppelpunkt (13) der drei oder mehr Ankoppelpunkte (13, 14, 15) gekoppelten ersten elektrischen Kontakt (23) und der zweite Signalleiter einen an einen zweiten Ankoppelpunkt (14) der drei oder mehr Ankoppelpunkte (13, 14, 15) gekoppelten zweiten elektrischen Kontakt (24) aufweist, wobei ein dritter, freier Ankoppelpunkt (15) näher an dem ersten (bzw. zweiten) Ankoppelpunkt (13 bzw. 14) als der zweite (bzw. erste) Ankoppelpunkt (14 bzw. 13) angeordnet ist.

2. Leiterplattenanordnung nach Anspruch 1, **dadurch gekennzeichnet, dass** der erste Ankoppelpunkt (13) und der zweite Ankoppelpunkt (14) zwei Ankoppelpunkte des Footprints (12) mit dem größten gegenseitigen Abstand (A) sind.

3. Leiterplattenanordnung nach Anspruch 1 oder 2, **dadurch gekennzeichnet, dass** der Footprint (12) vier Ankoppelpunkte aufweist, die in einem vorgegebenen Muster an der Leiterplatte (10) angeordnet sind.

4. Leiterplattenanordnung nach Anspruch 3, **dadurch gekennzeichnet, dass** die vier Ankoppelpunkte in Form eines Rechtecks, insbesondere in Form eines Quadrats an der Leiterplatte angeordnet sind, wobei die zwei elektrischen Kontakte (23, 24) an zwei diagonal gegenüberliegenden Ecken des Rechtecks angekoppelt sind.

5. Leiterplattenanordnung nach einem der vorhergehenden Ansprüche, **dadurch gekennzeichnet, dass** an zumindest einem oder mehreren weiteren Ankoppelpunkten (15) des Footprints (12) kein Kontaktelement des Steckverbinders (20) angekoppelt ist.

6. Leiterplattenanordnung nach einem der vorhergehenden Ansprüche, **dadurch gekennzeichnet, dass** die Ankoppelpunkte (13, 14, 15) jeweils Löcher, insbesondere Durchgangslöcher und/oder Lötstellen wie etwa Lötpads aufweisen, und/oder dass die Kontaktelemente (23, 24) pinartig oder stiftartig in Richtung der Leiterplatte (10) vorstehen.

7. Leiterplattenanordnung nach einem der vorhergehenden Ansprüche, **dadurch gekennzeichnet, dass** der Steckverbinder (20) eine zum Ankoppeln eines Twisted-Pair-Kabels eingerichtete Steckgeometrie (30) aufweist.

8. Leiterplattenanordnung nach einem der vorhergehenden Ansprüche, **dadurch gekennzeichnet, dass** der Steckverbinder (20) mehrere, bevorzugt vier in Befestigungsöffnungen (18) der Leiterplatte eingreifende Befestigungsvorsprünge (28) wie etwa Befestigungsstifte aufweist.

9. Leiterplattenanordnung nach einem der vorhergehenden Ansprüche, **dadurch gekennzeichnet, dass** der Footprint (12) zum Befestigen eines Sternviererkabel-Steckverbinders, insbesondere eines HSD-Steckers, eingerichtet ist und/oder dass der Steckverbinder (20) ein Twisted-Pair-Kabel-Steckverbinder, insbesondere ein MTD-Stecker ist.

## Claims

1. Printed circuit board assembly (100) with a printed circuit board (10) including at least one footprint (12) for attachment of a plug connector (20), said footprint (12) having three or more coupling points (13, 14, 15) for coupling electrical contacts (23, 24) of the plug connector (20), and with a plug connector (20) attached to the footprint (12),
**characterised in that**
the plug connector (20) has exactly two signal conductors for transmitting a differential signal, wherein the first signal conductor has a first electrical contact (23) coupled at a first coupling point (13) of the three or more coupling points (13, 14, 15) and the second signal conductor has a second electrical contact (24) coupled at a second coupling point (14) of the three or more coupling points (13, 14, 15), wherein a third, free coupling point (15) is arranged closer to the first (or second) coupling point (13 or 14) than the second (or first) coupling point (14 or 13) .

2. Printed circuit board assembly according to claim 1, **characterised in that** the first coupling point (13) and the second coupling point (14) are two coupling points of the footprint (12) with the greatest distance (A) between them.

3. Printed circuit board assembly according to claim 1 or 2, **characterised in that** the footprint (12) has four coupling points which are arranged in a predetermined pattern on the printed circuit board (10).

4. Printed circuit board assembly according to claim 3, **characterised in that** the four coupling points are arranged on the printed circuit board in the form of a rectangle, in particular in the form of a square, wherein the two electrical contacts (23, 24) are coupled at two diagonally opposite corners of the rectangle.

5. Printed circuit board assembly according to one of the preceding claims,
**characterised in that** no contact element of the plug connector (20) is coupled at at least one or several further coupling points (15) of the footprint (12).

6. Printed circuit board assembly according to one of the preceding claims,
**characterised in that** the coupling points (13, 14, 15) in each case have holes, in particular through-holes and/or solder points such as solder pads, and/or that the contact elements (23, 24) project in the manner of a pin or tab in the direction of the printed circuit board (10).

7. Printed circuit board assembly according to one of the preceding claims,
**characterised in that** the plug connector (20) has a plugging geometry (30) configured for coupling of a twisted pair cable.

8. Printed circuit board assembly according to one of the preceding claims,
**characterised in that** the plug connector (20) has several, preferably four, attachment projections (28), for example attachment pins, which engage in attachment openings (18) in the printed circuit board.

9. Printed circuit board assembly according to one of the preceding claims,
**characterised in that** the footprint (12) is configured for attachment of a star quad cable plug connector, in particular of an HSD plug and/or that the plug connector (20) is a twisted pair cable plug connector, in particular an MTD plug.

## Revendications

1. Ensemble de carte à circuits imprimés (100) comportant une carte à circuits imprimés (10) avec au moins une empreinte (12) pour fixer un connecteur d'enfichage (20), l'empreinte (12) présentant trois points de couplage (13, 14, 15) ou plus pour coupler des contacts électriques (23, 24) du connecteur d'enfichage (20), et comportant un connecteur d'enfichage (20) susceptible d'être fixé sur l'empreinte (12),
**caractérisé en ce que**
le connecteur d'enfichage (20) comprend précisément deux conducteurs de signal pour transmettre un signal différentiel, le premier conducteur de signal présentant un premier contact électrique (23) couplé à un premier point de couplage (13) parmi les trois points de couplage (13, 14, 15) ou plus, et le second conducteur de signal présentant un second contact électrique (24) couplé à un second point de couplage (14) parmi les trois points de couplage (13, 14, 15) ou plus, un troisième point de couplage libre (15) étant agencé plus près du premier (ou second) point de couplage (13 ou 14) que le second (ou premier) point de couplage (14 ou 13).

2. Ensemble de carte à circuits imprimés selon la revendication 1,
**caractérisé en ce que**
le premier point de couplage (13) et le second point de couplage (14) sont deux points de couplage de l'empreinte (12) ayant la plus grande distance mutuelle (A).

3. Ensemble de carte à circuits imprimés selon la revendication 1 ou 2,
**caractérisé en ce que**
l'empreinte (12) présente quatre points de couplage qui sont agencés selon un motif prédéterminé sur la carte à circuits imprimés (10).

4. Ensemble de carte à circuits imprimés selon la revendication 3,
**caractérisé en ce que**
les quatre points de couplage sont agencés en forme de rectangle, en particulier en forme de carré, sur la carte à circuits imprimés, les deux contacts électriques (23, 24) étant couplés à deux coins diagonalement opposés du rectangle.

5. Ensemble de carte à circuits imprimés selon l'une des revendications précédentes,
**caractérisé en ce que**
aucun élément de contact du connecteur d'enfichage (20) n'est couplé à au moins un ou plusieurs autres points de couplage (15) de l'empreinte (12).

6. Ensemble de carte à circuits imprimés selon l'une des revendications précédentes,
**caractérisé en ce que**
les points de couplage (13, 14, 15) présentent chacun des trous, en particulier des trous traversants et/ou des emplacements brasés, tels que des pastilles de brasage, et/ou **en ce que** les éléments de contact (23, 24) dépassent sous forme de plots ou de tiges en direction de la carte à circuits imprimés (10).

7. Ensemble de carte à circuits imprimés selon l'une des revendications précédentes,
**caractérisé en ce que**
le connecteur d'enfichage (20) présente une géométrique d'enfichage (30) conçue pour coupler un câble à paires torsadées.

8. Ensemble de carte à circuits imprimés selon l'une des revendications précédentes,
**caractérisé en ce que**
le connecteur d'enfichage (20) comprend plusieurs, de préférence quatre saillies de fixation (28), telles que des tiges de fixation, qui viennent s'engager dans des ouvertures de fixation (18) de la carte à circuits imprimés.

9. Ensemble de carte à circuits imprimés selon l'une des revendications précédentes,
**caractérisé en ce que**
l'empreinte (12) est conçue pour fixer un connecteur d'enfichage de câble quarte étoile, en particulier un connecteur mâle HSD, et/ou **en ce que** le connecteur d'enfichage (20) est un connecteur d'enfichage de câble à paires torsadées, en particulier un connecteur mâle MTD.
